Europäisches Patentamt

European Patent Office

Office européen des brevets

(19)

(11) Veröffentlichungsnummer: **0 213 496**
**B1**

(12) # EUROPÄISCHE PATENTSCHRIFT

(45) Veröffentlichungstag der Patentschrift:
24.01.90

(21) Anmeldenummer: 86111224.1

(22) Anmeldetag: 13.08.86

(51) Int. Cl.⁴: **H05K 13/04**

(54) Vorrichtung zum Bestücken von Leiterplatten.

(30) Priorität: 26.08.85 DE 3530452

(43) Veröffentlichungstag der Anmeldung:
11.03.87 Patentblatt 87/11

(45) Bekanntmachung des Hinweises auf die Patenterteilung:
24.01.90 Patentblatt 90/4

(84) Benannte Vertragsstaaten:
DE FR GB IT

(56) Entgegenhaltungen:
EP-A- 0 142 076
DE-A- 3 318 110
DE-A- 3 346 822
FR-A- 2 476 964
US-A- 4 309 808
US-A- 4 485 548

(73) Patentinhaber: Siemens Aktiengesellschaft,
Wittelsbacherplatz 2, D-8000 München 2(DE)

(72) Erfinder: Richter, Martin, Schulstrasse 20,
D-8525 Marloffstein(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Vorrichtung zum Bestücken von Leiterplatten mit elektronischen Bauelementen, deren Anschlußfüße in Anschlußöffnungen der auf einem Amboß aufliegenden Leiterplatte einfügbar sind, zwecks Abbiegen und Abschneiden der Anschlußfahnen mittels geeigneter Schneidwerkzeuge aus je einem feststehenden und je einem beweglichen Schneidmesser, wobei Überwachungseinrichtungen für die auf der den Bauelementen gegenüberliegenden Seite der Leiterplatte aus den Anschlußöffnungen herausragenden Anschlußfußenden vorgesehen sind.

Beim Einsetzen von beispielsweise 4- bis 40-poligen IC-Bauelementen durch Bestückautomaten können Durchsteckfehler auftreten. Dabei stehen die als Metallfahnen ausgebildeten Anschlußfüße der Bauelemente vereinzelt außerhalb ihres Kontaktier-Lochbereiches und knicken beim Einsetzen um. Als unerwünschte Folge ergeben sich dadurch fehlerhafte Kontaktierungen. Bisher werden daher durchweg alle automatisch bestückten Flachbaugruppen nach dem Einsetzvorgang einer visuellen Kontrolle unterzogen, wobei insbesondere die Paarigkeit der durchgesteckten Anschlußfüße pro Bauelement zu prüfen ist.

Zur Vereinfachung der oben beschriebenen Sichtkontrolle werden seit einiger Zeit in der Praxis die Anschlußfüße mittels Kohlepapier und Gummi-Andruckwalze auf neutralem Papier abgebildet, wodurch die Kontrolle einfacher wird. Aus der DE-OS 33 18 110 ist es bekannt, bei einer Vorrichtung zum Bestücken von Leiterplatten den zugehörigen Amboß mit einer optischen Überwachungseinrichtung für die auf der den Bauelementen gegenüberliegenden Seite der Leiterplatte aus den Anschlußöffnungen herausragenden Anschlußfußenden zu versehen. Daneben ist aus der DE-OS 33 40 147 bekannt, wenigstens eines der Schneidmesser schneidkantenseitig durch parallele Schlitze in einzelne Schneidzungen zu unterteilen, von denen jede einen Dehnungsmeßstreifen trägt, deren Signale in einer Auswerteeinheit erfaßbar sind.

Letztere Vorrichtung hat den Vorteil, daß die beim Schnitt wirkenden Druck- und Biegekräfte auf die feststehenden Schneidenbereiche unmittelbar über die den Schneidenbereichen zugeordneten Dehnungsmeßstreifen ein elektrisches Signal für jeden Anschlußfuß erzeugen, das auf einem Sichtgerät darstellbar und entsprechend auswertbar ist. Dieses Verfahren hat sich bereits in der Praxis bewährt. In Kauf genommen wird dabei, daß die Messer des Schneidwerkzeuges regelmäßig ausgetauscht werden müssen und dabei für jedes neue Messer der Aufwand für die Applikation, Kontaktierung und den Schutz der Dehnungsmeßstreifen getroffen werden muß.

Aufgabe der Erfindung ist es demgegenüber, eine Vorrichtung der eingangs genannten Art zu schaffen, die unabhängig von dem auszutauschenden Werkzeug verwendet werden kann.

Die Aufgabe wird erfindungsgemäß dadurch gelöst, daß jedem Anschlußfuß ein magnetfeldabhängiger Sensor zugeordnet ist, dessen Betätigungsmagnet durch das Abbiegen und -schneiden der zu überwachenden Anschlußfahnen über eine Schubstange bewegbar ist. Dabei sind vorzugsweise die einzelnen Schubstangen in lateralem Abstand unter Federdruck zwischen den feststehenden und beweglichen Schneidmessern geführt.

Im Rahmen der Erfindung werden durch den Federdruck die Schubstangen in einer mit der Schneidkante des feststehenden Messers bündig oder vorstehend verlaufende Position gedrückt. Erfolgt ein Biege- und/oder Schneidvorgang, so wird das Anschlußfußende eines Bauelementes um die Lochkante der Leiterplatte in eine Schräglage gezogen, wodurch die Schubstange nach hinten weggedrückt wird. Dieser Vorgang setzt sich fort, bis das überstehende Reststück durch den Quetschschnitt abgetrennt worden ist.

Besonders vorteilhaft ist bei der Erfindung, daß die zum Überwachen verwendeten Bauteile nicht unlösbar mit den auswechselbaren Messern des Schneidwerkzeuges verbunden sind. Zweckmäßigerweise sind im beweglichen Messer an der zum feststehenden Messer zugewandten Seite Nuten zur Führung der Schubstangen eingebracht. Dabei realisiert in bekannter Weise das feststehende Messer das Obermesser und das bewegliche Messer das Untermesser des Schneidwerkzeuges.

Bei der Erfindung lassen sich als magnetfeldabhängige Sensoren für den geringen Hub der Schubstangenbewegung, der im Bereich von etwa 0,4 bis 0,8 mm liegen kann, vorteilhafterweise Hallgeneratoren oder Feldplatten verwenden, die von endständig an den Schubstangen angeordneten Quadermagneten betätigt werden. Dadurch ergeben sich Signalverläufe mit Nulldurchgang, der besonders für eine gute Reproduzierbarkeit voreingestellter Schaltpunkte geeignet ist, wodurch solche Sensoren insbesondere optischen Sensoren überlegen sind. Der Nulldurchgang der Hallspannung kann in einfacher Weise mittels Anpaßverstärker zur Digitalisierung der Signale verwendet werden.

Im Rahmen der Erfindung ist es weiterhin vorteilhaft, daß die Schubstangen rückseitig abgekröpft sind und an ihrem oberen Ende die Quadermagnete tragen. Dabei kann eine Trägereinheit für die Magnete rückseitig justierbar an der Schubstange angeordnet sein. Es ergibt sich dadurch die Möglichkeit der Voreinstellung der Überwachungszone von Magnet und Hallgenerator für jede Schubstange.

Durch die Erfindung ist es nunmehr möglich, das obere Schneidmesser als Standard-Austauschteil zu wechseln. Zum Austausch des unteren Schneidmessers müssen jeweils die Schubstangen herausgenommen werden.

Weitere Einzelheiten und Vorteile der Erfindung ergeben sich aus der nachfolgenden Figurenbeschreibung von Ausführungsbeispielen anhand der Zeichnung in Verbindung mit den Patentansprüchen.

Es zeigen

FIG 1 eine perspektivische Darstellung und

FIG 2 eine Explosionsdarstellung des Werkzeuges eines bekannten Bestückungsautomaten,

FIG 3 und 4 die Seitenansicht und Draufsicht eines Schneidmessers für einen erfindungsgemäß ausgebildeten Bestückungsautomaten und

FIG 5 einen Seitenausschnitt einer in spezieller Weise weitergebildeten Vorrichtung gemäß der Erfindung.

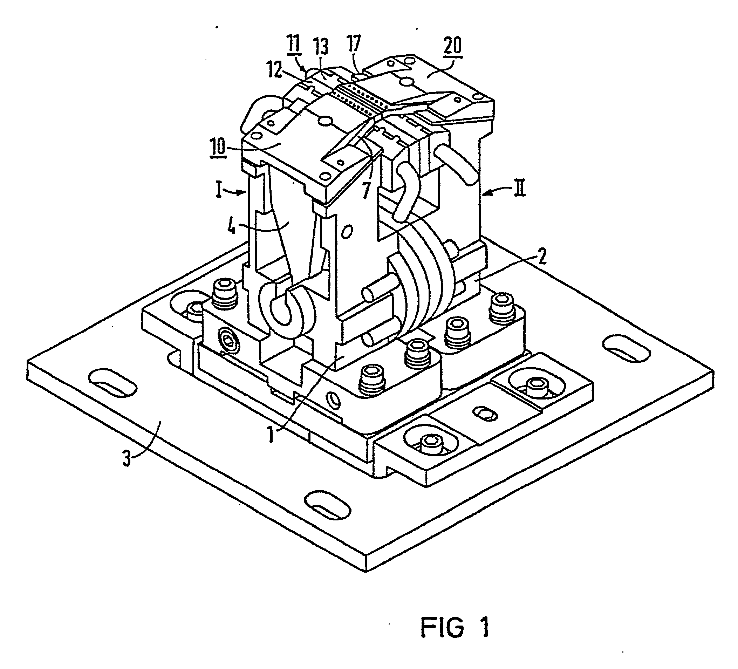

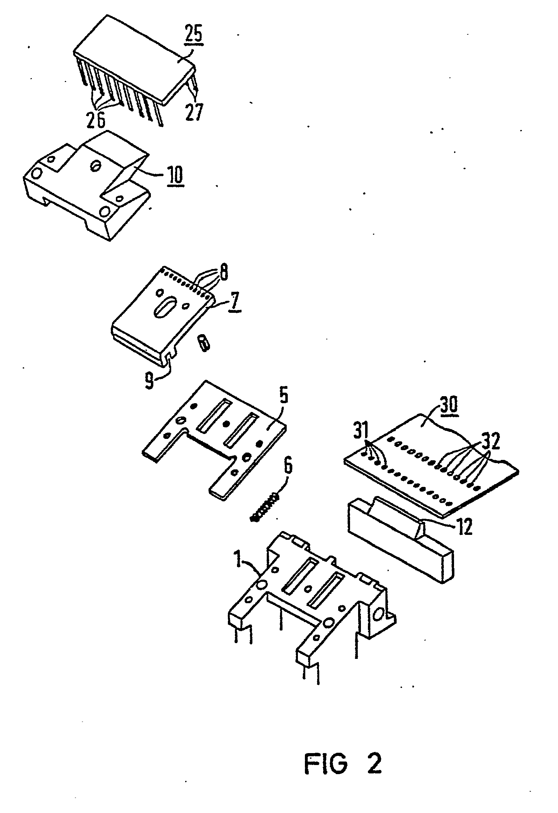

In den Figuren sind identische Teile mit den gleichen Bezugszeichen versehen. Insbesondere in FIG 1 und FIG 2 sind nur die zum Verständnis der Erfindung notwendigen Einzelteile erläutert.

FIG 1 zeigt eine handelsübliche Bestückungsvorrichtung, die im wesentlichen aus zwei spiegelbildlich zueinander stehenden Werkzeugeinheiten I und II besteht, welche nachfolgend im einzelnen erläutert werden:

Es bedeuten 1 und 2 jeweils Haltebacken, die auf einem Gerüst verschiebbar gegenüber gegenüber einer Grundplatte 3 geführt sind. Wie im einzelnen aus der Explosionsdarstellung nach FIG 2 hervorgeht, sind auf dem Haltebacken 1 über eine Zwischenplatte 5 ein verschiebbares Untermesser 7 und ein feststehendes Obermesser 10 gehalten. In der Zwischenplatte 5 sind Federn 6 zur Rückstellung des verschiebbaren Messers 7 angeordnet. Das Messer 7 weist im einzelnen Durchbohrungen 8 für die Füße von Bauelementen auf. Betätigt wird das Schneidmesser 7 durch einen Kipphebel 4, der in FIG 1 ersichtlich ist und der in eine Nut 9 des Schneidmessers 7 eingreift.

In der Schneideinheit II sind die den Teilen 4 bis 10 entsprechenden Einzelheiten mit 14 bis 20 bezeichnet, wobei in FIG 1 die Untermesser 7 und 17 unter den Obermessern 10 und 20 erkennbar sind. Zwischen den beiden Schneidwerkzeugen ist ein Amboß 11 angeordnet, der aus Einheiten 12 und 13 besteht und Ausnehmungen sowie Abführungen für Schneidabfälle und dergleichen aufweist. In FIG 2 ist weiterhin ein vielpoliges IC-Bauelement 25 angedeutet, das mit seinen zwei Reihen von Anschlußfüßen 26 und 27 in die Reihe von Durchtrittsöffnungen 31 bzw. 32 einer Leiterplatte eingesteckt werden soll. Dem Steckvorgang folgt bei der bekannten Vorrichtung ein automatisches Abbiegen und Abschneiden der als Fahnen ausgebildeten Anschlußfüße 26 und 27.

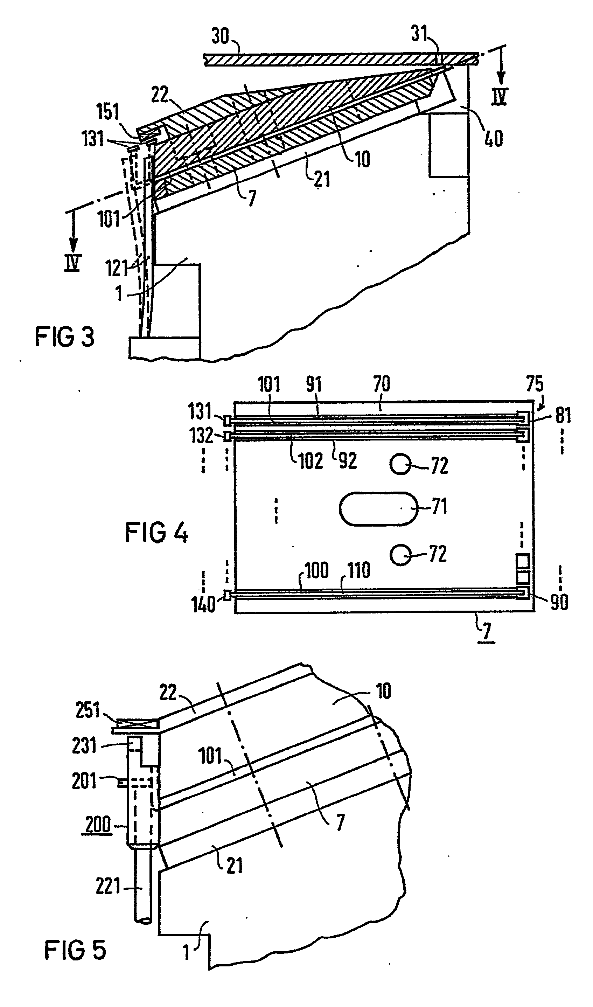

In FIG 3 ist eine Vorrichtung gemäß FIG 1 aus Schneidwerkzeug mit einer Überwachungseinrichtung für Anschlußfahnen komplettiert. Es bedeuten wiederum 1 der Haltebakken des Schneidapparates, auf dem das bewegliche Untermesser 7 und das feststehende Obermesser 10 angeordnet sind. Weiterhin sind ein Gleitblech 21 zwischen Untermesser 7 und dem Haltebacken 1 und eine Auflage 40 vorhanden, die im wesentlichen den Einheiten 5 und 12 der Fig. 2 entsprechen. Die gesamte Anordnung wird durch Schraubverbindungen zusammengehalten, wozu über dem Obermesser 10 zusätzlich eine Halteeinheit 22 angebracht ist, die gleichzeitig als Halterung für Überwachungsmittel dienen kann. Die mit Bauelementen zu bestückende Leiterplatte 30 befindet sich bei der Bestückung über dieser Anordnung, wobei eine der Durchtrittsöffnungen 31 erkennbar ist. Die Durchtrittsöffnung 31 liegt über zugehörigen Öffnungen im beweglichen Untermesser 7.

Zwischen Untermesser 7 und Obermesser 10 sind in vorgegebener Lateralposition Schubstangen angebracht, von denen in FIG 3 eine einzige mit 101 bezeichnet ist. Die Schubstange 101 wird durch Stabfedern 120 derart geführt, daß sie mit ihrem vorderen Ende bündig an der Kante des Obermessers 10 abschließt. Sie kann aber auch darüber hinausstehen. Rückseitig ist die Schubstange 101 abgekröpft, wobei an ihrem oberen Ende ein Quadermagnet 131 angebracht ist. Demgegenüber befindet sich an der unteren Seite der Abdeckplatte 22 in einer entsprechen den Aussparung ein Hallgenerator 151, der von dem Quadermagneten 131 aktiviert werden kann. Statt Hallgeneratoren können auch Feldplatten verwendet werden.

In der Draufsicht auf das Schneidmesser 7 gemäß FIG 4 ist erkennbar, daß für jedes der Anschlußenden eine entsprechende Anordnung aus Schubstange, Quadermagnet und zugehörigem Hallgenerator vorhanden ist. Die Oberfläche des Schneidmessers ist hier mit 70 bezeichnet, worin Aussparungen 71 bis 73 für die Aufnahme von Befestigungsmitteln eingearbeitet sind. An der proximalen Kante 75, also gegenüber der Schneidkante des feststehenden Obermessers 10, sind jeweils nebeneinanderliegend Aussparungen 81 bis 90 für die Aufnahme der Anschlußbeine eingebracht. In der speziellen Ausbildung gemäß FIG 3 sind nun in die Deckfläche 70 des Schneidmessers 7 parallele Nuten 91 bis 100 eingebracht, in denen einzelne Schubstangen 101 bis 110 geführt sind. Rückseitig weisen die Schubstangen 101 bis 110 die Quadermagnete 131 bis 140 auf.

Bei der anhand der Figuren 3 und 4 beschriebenen Anordnung wird also beim Bestücken der Leiterplatten mit Bauelementen unmittelbar der Biege- und Schneidvorgang für die einzelnen Anschlußbeine abgefragt: Die Abtastung der einzelnen Anschlußfüße erfolgt über die Schubstangen 101 bis 110, die im beweglichen Schneidmesser 7 eingearbeitet sind. Die Schubstangen 101 bis 110 werden durch die Stabfedern 121 bis 130 jeweils soweit nach vorn gedrückt, daß sie mit der Schneidkante des Obermessers 10 bündig oder definiert davor liegen. Erfolgt ein Biege-/Schneidvorgang, so zieht das Untermesser 7 das Anschlußfußende um die Lochkante der Leiterplatte 30 in eine Schräglage, wobei jeweils die entsprechende Schubstange nach hinten weggedrückt wird. Dieses Wegdrücken setzt sich fort, bis das überstehende Anschlußfuß-Reststück durch den Quetschschnitt abgetrennt worden ist. Wenn die Schneidkante des Untermessers 7 selbst die Schubstange nach hinten drückt, ist der Meßvorgang beendet.

Bei der beschriebenen Anordnung wird die Bewegung der einzelnen Schubstangen, die im Bereich von 0,4 bis 0,8 mm liegen wird, vorteilhafterweise durch Hallgeneratoren erfaßt, die von den Quadermagneten betätigt werden. Der wesentliche Vorteil einer solchen Abtastung besteht darin, daß sich Signalverläufe mit Nulldurchgang ergeben, was sich besonders für die gute Reproduzierbarkeit voreingestellter Schaltpunkte eignet. Der Nulldurchgang der Hallspannung kann dabei in einfacher Weise mittels Anpaßverstärker zur Digitalisierung der Signale ausgenutzt werden.

Außer Hallgeneratoren oder Feldplatten können auch andere magnetfeldabhängige Sensoren verwendet werden, sofern sie eine hinreichende Genauigkeit ermöglichen. Gegebenenfalls sind auch induktive Wegaufnehmer geeignet. Insbesondere gegenüber optischen Sensoren besteht der Vorteil, daß Verschmutzungen od.dgl. keine Meßverfälschungen verursachen. Es läßt sich somit eine praxisgerechte Überwachungsvorrichtung aufbauen.

In der FIG 5 ist die Anordnung nach FIG 3 in der Weise weitergebildet, daß eine Voreinstellung der Überwachungszone für jede Schubstange mit Magnet und zugeordnetem Hallgenerator ermöglicht wird. Es bedeuten wiederum 1 der Haltebacken mit darauf über dem Gleitblech 21 angeordneten Untermesser 7, Schubstange 101 und darüber befindlichem Obermesser 10. Rückseitig ist der abgekröpfte Teil der Schubstange 101 in eine Trägereinrichtung 200 eingepaßt, die an ihrem oberen Ende einen integrierten Quadermagneten 231 trägt. Demgegenüber liegt die Halteplatte 22 als Tragelement mit einer darauf befindlichen Feldplatte 251, welche gleichzeitig auch eine gedruckte Schaltung für die Aufbereitung der magnetfeldabhängigen Spannungen und Erzeugung von digitalen Verarbeitungssignalen aufweisen kann.

Mit der Trägereinrichtung 200 kann die Lage des Quadermagneten 231 für die Schubstange 101 einzeln justiert werden. Von unten greift die Stabfeder 221 in die Haltungseinrichtung ein und drückt gegen den abgekröpften Teil der Schubstange 101. Dabei ist über eine Justierschraube 201 die relative Lage der Trägereinrichtung 200 mit Quadermagneten 131 zur zugeordneten Feldplatte 251 einzeln einstellbar. Durch eine derartige Justierung kann eine spezifische Signalanpassung für jedes einzelne Überwachungselement entsprechend erfolgen.

Bei den beschriebenen Ausführungsformen der Erfindung ist vorteilhaft, daß die Überwachungselemente die Biege- und Schneidfunktion des Schneidwerkzeuges nicht beeinflussen, da sie außerhalb der Wirkungszone der Messerschneiden sitzen. Zur Modifizierung bekannter Bestückautomaten im Sinne der beschriebenen Erfindung brauchen im wesentlichen nur in die Untermesser des Schneidwerkzeuges entsprechende Nuten für die Schubstangen eingearbeitet werden. Letzteres kann durch Funkenerosion in kostengünstiger Weise erfolgen. Beim Betrieb einer derartigen Vorrichtung ist es bei Stumpfwerden der Schneidmesser möglich, diese problemlos zu wechseln.

## Patentansprüche

1. Vorrichtung zum Bestücken von Leiterplatten mit elektronischen Bauelementen, deren Anschlußfüße in Anschlußöffnungen der auf einem Amboß aufliegenden Leiterplatte einfügbar sind zwecks Abbiegen und Abschneiden der Anschlußfahnen mittels geeigneter Schneidwerkzeuge aus je einem feststehenden und je einem beweglichen Schneidmesser, wobei Überwachungseinrichtungen für die auf der den Bauelementen gegenüberliegenden Seite der Leiterplatte aus den Anschlußöffnungen herausragenden Anschlußfußenden vorgesehen sind, **dadurch gekennzeichnet,** daß jedem Anschlußfuß (26,27) ein magnetfeldabhängiger Sensor (151,251) zugeordnet ist, dessen Betätigungsmagnet (131 - 140, 231) durch das Abbiegen und -schneiden der zu überwachenden Anschlußfahne über eine Schubstange (101 - 110) bewegbar ist.

2. Vorrichtung nach Anspruch 1, **dadurch gekennzeichnet,** daß die einzelnen Schubstangen (101 - 110) in lateralem Abstand unter Federdruck zwischen den feststehenden und beweglichen Schneidmessern (7, 10) geführt sind.

3. Vorrichtung nach Anspruch 1, **dadurch gekennzeichnet,** daß durch den Federdruck die Schubstangen (101 - 110) in eine mit der Schneidkante (75) des feststehenden Messers (10, 20) bündig oder vorstehend verlaufende Ruheposition gedrückt werden.

4. Vorrichtung nach Anspruch 1, **dadurch gekennzeichnet,** daß im beweglichen Messer (7, 17) an der zum feststehenden Messer (10, 20) zugewandten Fläche im lateralen Abstand Aussparungen (91 - 100) zur Führung der Schubstangen (101 - 110) vorhanden sind.

5. Vorrichtung nach Anspruch 1, **dadurch gekennzeichnet,** daß das feststehende Messer (10, 20) das Obermesser und das bewegliche Messer (7, 17) das Untermesser des Schneidwerkzeuges (1) ist.

6. Vorrichtung nach Anspruch 1, **dadurch gekennzeichnet,** daß die magnetfeldabhängigen Sensoren Hallgeneratoren (151) sind, die von an den Schubstangen (101 - 110) endständig angeordneten Quadermagneten (131 - 140, 231) aktivierbar sind.

7. Vorrichtung nach Anspruch 1, **dadurch gekennzeichnet,** daß die magnetfeldabhängigen Sensoren Feldplatten (251) sind, die von an den Schubstangen (101 - 110) endständig angeordneten Quadermagneten (231) aktivierbar sind.

8. Vorrichtung nach Anspruch 7, **dadurch gekennzeichnet,** daß die Schubstangen (101 - 110) rückseitig abgekröpft sind und an ihren oberen Enden die Quadermagnete (131 - 140, 231) tragen.

9. Vorrichtung nach Anspruch 8, **dadurch gekennzeichnet,** daß eine Trägereinheit (200) für die Magnete rückseitig justierbar an der Schubstange (101 - 110) angeordnet ist.

10. Vorrichtung nach Anspruch 6 oder 7, **dadurch gekennzeichnet,** daß der Hallgenerator (151) oder die Feldplatte (251) ortsfest an der Halterung (22) für das Schneidwerkzeug (1) als Wechseleinheit angebracht ist.

11. Vorrichtung nach einem der vorhergehenden Ansprüche, **dadurch gekennzeichnet,** daß die Halterung (22) gleichermaßen als Träger einer Auswerteschaltung für die magnetfeldabhängigen Signale ausgebildet ist.

## Claims

1. Device for assembling printed-circuit boards with electronic components, the terminal feet of which are able to be inserted into terminal openings of the printed-circuit board lying resting on an anvil, for the purpose of bending away and cutting off the terminal lugs by means of suitable cutting tools comprising in each case a stationary and in each case a mobile cutting blade, whereby monitoring devices are provided for terminal feet ends projecting from the terminal openings on the side of the printed-circuit board opposite the components, characterised in that associated with each terminal foot (26, 27) there is a magnetic-field-dependent sensor (151, 251), the control electro-magnet (131–140, 231) of which is movable by way of a push rod (101–110) as a result of the bending away and cutting off of the terminal lug which is to be monitored.

2. Device according to claim 1, characterised in that the individual push rods (101–110) are guided, with lateral clearance, under spring pressure, between the stationary and mobile cutting blades (7, 10).

3. Device according to claim 1, characterised in that under spring pressure the push rods (101–110) are pressed into a resting position by the cutting edge (75) of the stationary blade (10, 20), so that they are flush or project.

4. Device according to claim 1, characterised in that in the mobile blade (7, 17) on the face facing the stationary blade (10, 20) recesses (91–100) are provided, with lateral clearance, for guiding the push rods (101–110).

5. Device according to claim 1, characterised in that the stationary blade (10, 20) is the upper blade and the mobile blade (7, 17) the lower blade of the cutting tool (1).

6. Device according to claim, characterised in that the magnetic-field-dependent sensors are Hall generators (151), which are able to be activated by cuboid magnets (131–140, 231) arranged end-upwards on the push rods (101–110).

7. Device according to claim 1, characterised in that the magnetic-field-dependent sensors are magnetoresistors (251), which are able to be activated by cuboid magnets (231) arranged end-upwards on the push rods (101–110).

8. Device according to claim 7, characterised in that the push rods (101–110) are bent at an angle on the rear side and carry on their upper ends the cuboid magnets (131–140, 231).

9. Device according to claim 8, characterised in that a carrier unit (200) for the magnets is adjustably arranged on the rear side on the push rod (101–110).

10. Device according to claim 6 or 7, characterised in that the Hall generator (151) or the magnetoresistor (251) is attached securely as an exchangeable unit on the holder (22) for the cutting tool (1).

11. Device according to one of the preceding claims, characterised in that the holder (22) is constructed in the same way as the carrier of an evaluating circuit for the magnetic-field-dependent signals.

## Revendications

1. Dispositif pour équiper des circuits imprimés de composants électroniques dont les sorties peuvent être insérées dans des trous de connexion du circuit imprimé, disposé sur une enclume en vue du repliage et de la coupe des sorties au moyen d'outils de coupe appropriés, comprenant chacun une lame fixe et une lame mobile, avec prévision d'organes de contrôle pour les extrémités des sorties dépassant des trous de connexion sur le côté du circuit imprimé opposé aux composants, caractérisé par la coordination à chaque sortie (26, 27) d'un capteur (151, 251) sensible à un champ magnétique, qui est actionné par un aimant (131–140, 231) déplaçable par l'intermédiaire d'une tige (101–110) par le pliage et la coupe de la sortie à contrôler.

2. Dispositif selon la revendication 1, caractérisé en ce que les différentes tiges (101, 110) sont guidées latéralement à distance les unes des autres et sous la pression de ressorts entre les lames fixe et mobile (7, 10).

3. Dispositif selon la revendication 1, caractérisé en ce que les tiges (101–110) sont pressées par les ressorts à une position de repos où les extrémités des tiges affleurent ou font saillie vers l'avant par rapport au tranchant (75) de la lame fixe (10, 20).

4. Dispositif selon la revendication 1, caractérisé en ce que des évidements (91–100) pour le guidage des tiges (101–110) existent, à distance latérale les uns des autres, dans la surface de la lame mobile (7, 17) dirigée vers la lame fixe (10, 20).

5. Dispositif selon la revendication 1, caractérisé en ce que la lame fixe (10, 20) est la lame supérieure et la lame mobile (7, 17) est la lame inférieure de l'outil de coupe (1).

6. Dispositif selon la revendication 1, caractérisé en ce que les capteurs sensibles au champ magnétique sont des générateurs Hall (151) pouvant être commandés par des aimants parallélépipédiques (131–140, 231) disposés aux extrémités arrières des tiges (101–110).

7. Dispositif selon la revendication 1, caractérisé en ce que les capteurs sensibles au champ magnétique sont des magnétorésistances (251) pouvant être commandées par des aimants parallélépipédiques disposés aux extrémités arrières des tiges (101–110).

8. Dispositif selon la revendication 7, caractérisé en ce que les tiges (101–110) sont coudées vers le haut à l'arrière et portent les aimants parallélépipédiques (131–140, 231) à leurs extrémités supérieures.

9. Dispositif selon la revendication 8, caractérisé en ce qu'une unité de support (200) pour les aimants est disposée réglable à l'arrière des tiges (101–110).

10. Dispositif selon la revendication 6 ou 7, caractérisé en ce que le générateur Hall (151) ou la magnétorésistance (251) est disposé fixe sur l'organe de maintien (22) pour l'outil de coupe (1), lequel constitue une unité interchangeable.

11. Dispositif selon une des revendications précédentes, caractérisé en ce que l'organe de maintien (22) est réalisé en même temps en tant que support pour un circuit d'exploitation pour les signaux fonction du champ magnétique.

FIG 1

FIG 2

FIG 3

FIG 4

FIG 5